(19) Europäisches Patentamt
European Patent Office
Office européen des brevets

(11) **EP 2 987 189 B1**

(12) **EUROPEAN PATENT SPECIFICATION**

(45) Date of publication and mention of the grant of the patent:
**29.09.2021 Bulletin 2021/39**

(21) Application number: **14724933.8**

(22) Date of filing: **14.04.2014**

(51) Int Cl.:
*H01L 43/08* (2006.01)    *H01L 43/10* (2006.01)
*H01L 43/12* (2006.01)    *H01F 10/32* (2006.01)
*G11C 11/16* (2006.01)

(86) International application number:
**PCT/US2014/033913**

(87) International publication number:
**WO 2014/172225 (23.10.2014 Gazette 2014/43)**

(54) **SEED LAYER FOR PERPENDICULAR MAGNETIC ANISOTROPY (PMA) THIN FILM**

KEIMSCHICHT FÜR EINE DÜNNSCHICHT MIT SENKRECHTER MAGNETISCHER ANISOTROPIE

COUCHE DE GERME POUR FILM MINCE À ANISOTROPIE MAGNÉTIQUE PERPENDICULAIRE (PMA)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.04.2013 US 201313863545**

(43) Date of publication of application:
**24.02.2016 Bulletin 2016/08**

(73) Proprietor: **Taiwan Semiconductor Manufacturing Co., Ltd.**
**Hsinchu 300-78 (TW)**

(72) Inventors:
• **MORIYAMA, Takahiro**
**Tondabaya-shi**
**Osaka 584-0071 (JP)**
• **WANG, Yu-Jen**
**San Jose, CA 95130 (US)**
• **TONG, Ru-Ying**
**Los Gatos, CA 95032 (US)**

(74) Representative: **Schuffenecker, Thierry**
**120 Chemin de la Maure**
**06800 Cagnes-sur-Mer (FR)**

(56) References cited:
**WO-A1-2012/160937    WO-A1-2014/051943**
**US-A1- 2011 149 647    US-A1- 2012 068 139**
**US-A1- 2013 028 013    US-A1- 2013 078 482**

• **JI-HO PARK ET AL: "Perpendicular Magnetic Tunnel Junctions with CoFe/Pd Multilayer Electrodes and an MgO Barrier", IEEE TRANSACTIONS ON MAGNETICS, IEEE SERVICE CENTER, NEW YORK, NY, US, vol. 45, no. 10, 1 October 2009 (2009-10-01), pages 3476-3479, XP011277087, ISSN: 0018-9464, DOI: 10.1109/TMAG.2009.2023237**
• **None**

**Description**

**BACKGROUND**

1. Technical Field

This disclosure relates generally to magnetic devices that utilize thin film magnetic layers with perpendicular magnetic anisotropy (PMA), and more specifically, to seed layers for enhancing the PMA properties of such devices.

2. Description of the Related Art

Many present day magnetic devices utilize thin film depositions in which magnetic thin films may have in-plane (plane of deposition) magnetization directions, out-of-plane (i.e., perpendicular to the film plane) magnetization directions, which is often referred to as perpendicular magnetic anisotropy (PMA) or even components in both of such directions. Such devices include, but are not limited to:

(1) various designs of magnetic random access memory (MRAM), e.g., PMA (or Partial-PMA) Spin-Torque MRAM in which such films can serve as pinned layers, reference layers, free layers, or dipole (offset-compensation) layers;
(2) various designs of PMA spin valves, tunnel valves (magnetic tunnel junctions - MTJs) and PMA media used in magnetic sensors and magnetic data storage, and;
(3) other spintronic devices.

PMA layers are used in these devices for a variety of reasons. In spin-torque MRAMs, for example, the PMA layers, among other advantages, provide better functionality, better thermal stability and a reduction of switching currents.

The source of the PMA can either come from the bulk properties of the chosen materials or it can originate in the interface between the layers. To achieve better control of the PMA, multilayers that include at least one ferromagnetic material are commonly used.

One of these multilayers is the Co/Ni multilayer system. The PMA in this system arises from electronic band matching at the FCC (face centered cubic) (111)-oriented Co/Ni interface (see Daalderop et al., Phys. Rev. Lett., 68, 682 (1992)). Buffer layers and/or seed layers are typically needed to promote a smooth and better FCC(111)-oriented growth in the Co/Ni multilayers. In this regard, Fig's. 1 (a), (b) and (c) schematically illustrate configurations applied to the promotion of a FCC

(111) layer structure in a PMA multilayer system.

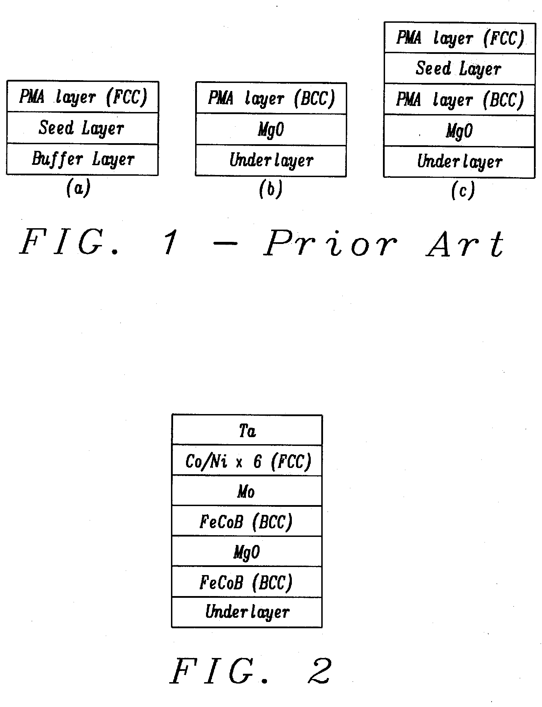

Fig. 1(a) shows schematically a FCC (111)-oriented PMA layer grown on a buffer layer and a seed layer. Fig. 1(b) shows schematically a BCC (body centered cubic) PMA layer, such as a Fe-based PMA layer, that is grown on an MgO tunnel barrier layer. Fig. 1(c) shows schematically an FCC (111)-oriented PMA layer grown on a BCC, Fe-based PMA layer via a seed layer that creates a smooth transition between the BCC and FCC symmetries.

In this disclosure, a buffer layer (as in Fig. 1(a)) is defined as a layer that makes a smooth and flat surface to facilitate the correspondingly smooth and flat growth of subsequently deposited layers. A seed layer (as in Fig's. 1(a) and (c)), on the other hand, is defined as a layer that operates as a template to produce a certain crystal-oriented growth of the following deposited layer (such as the FCC growth in (a) and (c)). Typical buffer layers (among others) are Ta/CuN, TaN/Cu and Ru/Ta. Typical seed layers for Co/Ni multilayers are Cu, CuN and NiCr, whose crystal structure is similar to Co and/or Ni. While the focus of this disclosure is mainly on the Co/Ni material system as an important exemplar, similar PMA multilayer systems, such as (Co,Fe)/Pt, (Co, Fe)/Pd, Co/Ru, Co/Ni/Pt, and Co/Ni/Fe/Pt will also benefit from the method to be described herein.

Specifically, the methods of this disclosure are intended to address a problem confronting material combinations used in current multilayer constructions for tunneling magnetoresistive (TMR) devices that include thin MgO tunnel barrier layers interfaced with Fe containing ferromagnetic layers. The problem referred to, is that such constructions are limited in the thickness ranges within which the PMA condition can be maintained because the PMA originates at a single interface. As the magnetic layer becomes thicker, the perpendicular anisotropy field will decrease and will eventually be overcome by the demagnetizing field (see equ. (1) below). This, in turn, will result in the magnetization moving within the plane of the film. Therefore it becomes difficult to maintain good thermal stability of the magnetization direction using only the MgO interface as the source of the magnetic anisotropy. Prior arts, such as those taught by Girt et al. (US Patent No. 7,666,529) and Wang et al. (US Publ. Pat. Appl. 2012/0141836), discuss aspects of interfaces between different crystalline structures, but do not treat the problem to be addressed herein.

US 2013/028013 discloses a magnetoresistive effect element which uses a perpendicularly magnetized material and has a high TMR ratio. Intermediate layers 31, 32 composed of an element metal having a melting point of 1600 DEG C. or an alloy containing the metal on an outside of a structure consisting of a CoFeB layer 41, an MgO barrier layer 10, and a CoFeB layer 42. By inserting the intermediate layers 31, 32, crystallization of the CoFeB layer during annealing is advanced from an MgO (001) crystal side, so that the CoFeB layer has a crystalline orientation in bcc (001).

WO 2012/160937 and US 2014/097509 disclose a disclosed magnetic memory element that includes: a magnetization free layer formed of a ferromagnetic substance having perpendicular magnetic anisotropy; a response layer provided so as to be opposed to the magnetization free layer and formed of a ferromagnetic substance having perpendicular magnetic anisotropy; a non-magnetic layer provided so as to be opposed to the response layer on a side opposite to the magnetization free layer and formed of a non-magnetic substance; and a reference layer provided so as to be opposed to the non-magnetic layer on a side opposite to the response layer and formed of a ferromagnetic substance having perpendicular magnetic anisotropy. The magnetization free layer includes a first magnetization fixed region and a second magnetization fixed region which have magnetization fixed in directions antiparallel to each other, and a magnetization free region in which a magnetization direction is variable.

US 2012/068139 discloses a magnetoresistive element including: a first ferromagnetic layer having an axis of easy magnetization in a direction perpendicular to a film plane; a second ferromagnetic layer having an axis of easy magnetization in a direction perpendicular to a film plane; a nonmagnetic layer placed between the first ferromagnetic layer and the second ferromagnetic layer; a first interfacial magnetic layer placed between the first ferromagnetic layer and the nonmagnetic layer; and a second interfacial magnetic layer placed between the second ferromagnetic layer and the nonmagnetic layer.; The first interfacial magnetic layer includes a first interfacial magnetic film, a second interfacial magnetic film placed between the first interfacial magnetic film and the nonmagnetic layer and having a different composition from that of the first interfacial magnetic film, and a first nonmagnetic film placed between the first interfacial magnetic film and the second interfacial magnetic film.

US 2011/149647 discloses a perpendicular magnetic tunnel junction (MTJ), a magnetic device including the same, and a method of manufacturing the MTJ, the perpendicular MTJ includes a lower magnetic layer; a tunnelling layer on the lower magnetic layer; and an upper magnetic layer on the tunnelling layer. One of the upper and lower magnetic layers includes a free magnetic layer that exhibits perpendicular magnetic anisotropy, wherein the magnetizing direction of the free magnetic layer is changed by a spin polarization current. A polarization enhancing layer (PEL) and an exchange blocking layer (EBL) are stacked between the tunnelling layer and the free magnetic layer.

JI-HO PARK et al. : "'Perpendicular Magnetic Tunnel Junctions with CoFe/Pd Multilayer Electrodes and an Mgo Barrier", IEEE TRANSACTIONS ON MAGNETICS, vol. 45, N°10, 1. October 2009, pages 3476-3479 is another prior art document.

US 2013/078482 discloses a magnetoresistive element that includes a free ferromagnetic layer comprising a reversible magnetization directed substantially perpendicular to a film surface, a pinned ferromagnetic layer comprising a fixed magnetization directed substantially perpendicular to the film surface, and a tunnel barrier layer disposed between the free and pinned ferromagnetic layers, wherein the free and pinned layers contain at least one element selected from the group consisting of Fe, Co, and Ni, at least one element selected from the group consisting of V, Cr, and Mo, and at least one element selected from the group consisting of B, P, C, and Si, and wherein the free layer, the tunnel barrier layer, and the pinned layer have a coherent body-centered cubic structure with a (001) plane oriented,; and a bidirectional spin-polarized current passing through the coherent structure in a direction perpendicular to the film surface reverses a magnetization direction of the free layer.

WO 2014/051943 discloses a Magnetic tunnel junctions (MTJ) suitable for spin transfer torque memory (STTM) devices, include perpendicular magnetic layers and one or more anisotropy enhancing layer(s) separated from a free magnetic layer by a crystallization barrier layer. In embodiments, an anisotropy enhancing layer improves perpendicular orientation of the free magnetic layer while the crystallization barrier improves tunnel magnetoresistance (TMR) ratio with better alignment of crystalline texture of the free magnetic layer with that of a tunneling layer.

## SUMMARY

The invention is defined by the claims. A first object of the present disclosure is to provide a method of maintaining perpendicular to the plane magnetic anisotropy (PMA) throughout a sequence of layers, when that perpendicular to the plane magnetic anisotropy originates at interlayer interfaces.

A second object of the present disclosure is to provide such a method that is specifically exemplified by its advantageous application to interfaces between MgO and Fe-containing ferromagnetic materials, but which is also applicable to other interlayer interfaces.

A third object of the present disclosure is to provide such a method that is applicable to an MgO interface with a Fe-containing ferromagnetic layer which is part of a PMA multilayer system such as Co/Ni layered systems.

A fourth object of the present disclosure is to provide such a method that is applicable to an MgO interface with a Fe-containing ferromagnetic layer which is part of a PMA multilayer system such as (Co,Fe)/Pt, (Co, Fe)/Pd, Co/Ru, Co/Ni/Pt, and Co/Ni/Fe/Pt layered systems.

A fifth object of the present disclosure is to fulfill the previous objects by means of providing advantageous coupling between layers having BCC and FCC crystal symmetry.

A sixth object of the present disclosure is to provide a method of inducing a crystal structure in a previously amorphous layer by means of a capping overlayer that acts as a template for crystal formation during an annealing process.

These objects will be met by growing PMA layers using combinations of the methods shown schematically in Fig's. 1(a), 1(b) and 1(c). With these methods, the perpendicular magnetic anisotropy will originate from both the MgO/Fe interface and the top PMA layer that is grown over that interface. The top layer is most likely an FCC(111) oriented Co/Ni multilayer construction as shown in Fig. 1(c). Furthermore, it may be more advantageous to maintain the magnetic coupling, i.e. RKKY (Ruderman-Kittel-Kasuya-Yosida long range) coupling, exchange coupling and/or dipolar coupling, between the FCC PMA layer and the BCC layer.

Unfortunately, it is challenging to find materials that can create a smooth crystalline transition from BCC to FCC crystal symmetry. Commonly used materials to achieve this purpose are Cr and its alloys. But these materials are known to deteriorate the tunnel magnetoresistance (TMR) as they diffuse into or within the vicinity of the MgO tunneling barrier layer. Therefore, in the present disclosure, it is proposed to use Mo, as well as Nb and V, to form a transition layer between BCC and FCC crystal symmetry materials. Examples of this approach are given by the following three blanket film configurations:

(#1) $Si/SiO_2$/Underlayer/FeCoB/MgO/FeCoB(1.2 nm)/Mo(1.0 nm)/[Co 0.23 nm/Ni 0.46 nm]x6/Ta/Capping layer. (Note, the Co thickness could be between $5x10^{-2}$ nm and $5x10^{-1}$ nm and the Ni thickness could range between $2x10^{-1}$ nm and 1 nm)

(#2) $Si/SiO_2$/Underlayer/FeCoB/MgO/FeCoB(1.2 nm)/Mo(1.2 nm)/[Co 0.23 nm/Ni 0.46 nm]x6/Ta/Capping layer. (Note, the Co thickness could be between $5x10^{-2}$ nm and $5x10^{-1}$ nm and the Ni thickness could range between $2x10^{-1}$ nm and 1 nm)

(#3) $Si/SiO_2$/Underlayer/FeCoB/MgO/FeCoB(1.2 nm)/Mo(1.4 nm)/[Co 0.23 nm/Ni 0.46 nm]x6/Ta/Capping layer. (Note, the Co thickness could be between $5x10^{-2}$ nm and $5x10^{-1}$ nm and the Ni thickness could range between $2x10^{-1}$ nm and 1 nm)

These three configurations, differing as shown in the thickness of the Mo transition layer, are annealed for 30 minutes at 400 °C following deposition and then measured in a polar Kerr magnetometer with the applied magnetic field perpendicular to the plane of the layers. The results indicate that the objects set forth above have been met and the details will now be discussed below.

## BRIEF DESCRIPTION OF THE DRAWINGS

Fig's. 1(a)-1(c) are three schematic illustrations showing different methods of producing crystalline symmetry when growing PMA layers.

Fig. 2 is a schematic illustration showing the particular layered configuration corresponding to blanket film #1 and also discussed in Fig. 4.

Fig's. 3 is a Kerr intensity plot vs. external magnetic field for three deposited blanket films containing Mo transition layers of different thicknesses.

Fig. 4 is a magnetoresistance curve for a patterned film corresponding to blanket film #1.

Fig. 5(a) and 5(b) are schematic illustrations showing the application of an Mo capping layer as a template.

## DETAILED DESCRIPTION

The present disclosure provides a method for providing enhanced PMA within a layered construction when the PMA originates at an interface between a layer of MgO and an Fe-containing ferromagnetic layer and where smooth transitions between BCC and FCC crystalline symmetries are promoted by a transition layer, such as a layer of Mo.

A recent advance in the development of MRAM (magnetic random access memory) devices is the use of the high interfacial PMA originating at the interface of MgO and Fe or Fe alloy, including FeCoB, FeB, etc., used as ferromagnetic layers (see Fig. 1(b)). Similarly to the Co/Ni interface discussed above, the MgO/Fe interface provides a strong PMA source (see, Ikeda et al., Nature Mater., 9, 721 (2010)). This material combination (and its interfacial property) is very advantageous for constructing high quality MTJs (magnetic tunneling junctions) that are used for memory elements in MRAMs, because these kinds of MTJ devices typically use a thin MgO tunneling barrier layer that also provides additional spin filtering between the Fe-based ferromagnetic electrodes (Butler et al., Phys. Rev B 63,054416, (2001)). This allows TMR ratios higher than 100%. This high ratio is dependent on a good lattice match at the MgO(001)[100]/Fe(001)[110] interfaces. Since MgO has a rocksalt crystal structure and Fe has a BCC crystal structure, a lattice matching at the MgO(001)[100]/Fe(001)[110] interface with a mismatch of only a few percent can be achieved.

Unfortunately, as was mentioned briefly above, this material combination has a limitation in the thickness range within which the PMA property can be maintained, given that it arises at a single interface. As the magnetic layer becomes thicker, the PMA field will decrease and eventually be exceeded by the demagnetizing field (see equation (1) below). This will cause the magnetization of the layer to move from perpendicularity to the plane of the layer, to be within the plane of the layer. Therefore it is difficult to achieve stable perpendicularity and thermal stability using only the MgO interface as the source of the PMA. It would be desirable if the PMA and the total magnetic moment could be separately controlled to allow the thermal stability to be improved as well as other properties.

$$(1) \quad H_k = K_s/M_s t - DM_s$$

Where $H_k$ is the anisotropy field, $K_s$ is the interfacial anisotropy energy at the MgO/Fe interface, D is the demagnetization factor, $M_s$ is the magnetic moment at saturation per unit volume and t is the thickness of the magnetic layer.

A solution to the problem of maintaining good PMA that originates at a single interface is to combine the growth structures of Fig's. 1(a) and 1(b), where the PMA will originate from both the MgO/Fe interface and the top PMA layer that is above the interface. This top layer is most likely a FCC(111) oriented layer such as Co/Ni multilayers as shown in Fig. 1(c). Furthermore, it may be more advantageous to maintain the magnetic coupling (RKKY, exchange, dipolar) between the FCC PMA layer and the BCC layer. As mentioned above, materials such as Cr and its alloys, that are known to promote coupling between different crystal symmetries, are also prone to diffuse into the MgO layer or its vicinity, lessening its effectiveness.

Consequently, as mentioned in the summary above, we propose the use of Mo (or Nb or V), rather than Cr, as a transition layer between BCC and FCC crystal symmetry. To establish the properties of Mo, and by extension, of Nb and/or V as well, we have analyzed three multilayered film depositions of the types described below, in which the Co/Ni multilayer is formed as a six-fold repetitive Co/Ni structure, where the Co is approximately 0.23 nm in thickness and the Ni is approximately 0.46 nm in thickness, although a range of Co thickness could be between $5 \times 10^{-2}$ nm and $5 \times 10^{-1}$ nm and the Ni thickness could range between $2 \times 10^{-1}$ nm and 1 nm:

(#1) Si/SiO$_2$/Underlayer/FeCoB/MgO/FeCoB(1.2 nm)/Mo(1.0 nm)/[Co 0.23 nm/Ni 0.46 nm]x6/Ta/Capping layer. (Note, the Co thickness could be between $5 \times 10^{-2}$ and $5 \times 10^{-1}$ nm and the Ni thickness could range between $2 \times 10^{-1}$ nm and 1 nm)

(#2) Si/SiO$_2$/Underlayer/FeCoB/MgO/FeCoB(1.2 nm)/Mo(1.2 nm)/[Co 0.23 nm/Ni 0.46 nm]x6/Ta/Capping layer. (Note, the Co thickness could be between $5 \times 10^{-2}$ nm and $5 \times 10^{-1}$ nm and the Ni thickness could range between $2 \times 10^{-1}$ nm and 1 nm)

(#3) Si/SiO$_2$/Underlayer/FeCoB/MgO/FeCoB(1.2 nm)/Mo(1.4 nm)/[Co 0.23 nm/Ni 0.46 nm]x6/Ta/Capping layer. (Note, the Co thickness could be between $5 \times 10^{-2}$ nm and $5 \times 10^{-1}$ nm and the Ni thickness could range between $2 \times 10^{-1}$ nm and 1 nm)

Referring to Fig. 2, there is shown schematically the layered structure corresponding to structure #1 described above. The PMA property is shown as originating at the MgO/ FeCoB interface. A layer of Mo serves as a transition layer (or seed layer) to serve as an interface between the BCC structure of the FeCoB and the FCC structure of the Co/Ni multiple layers above the Mo layer.

The transition layer of Mo thereby propagates the PMA property to the layers formed upon it.

The transition layers of Mo as formed within the above multi-layered structures can be formed within ferromagnetic free layers or pinned layers of, for example, MTJ sensor fabrications or MRAM elements (with appropriate MgO thicknesses), where their crystal-structure transition properties would produce enhancements of sensor performance.

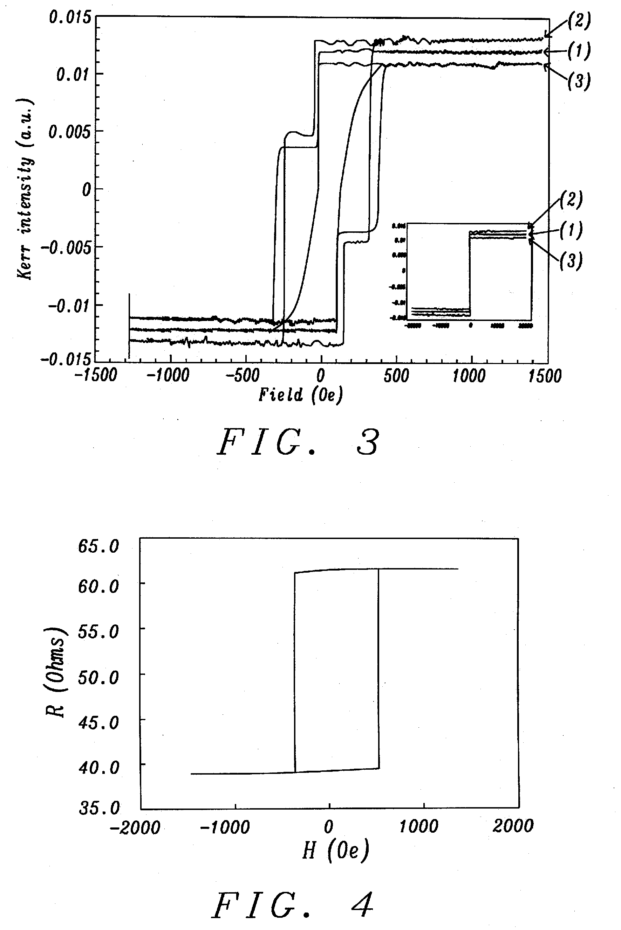

These three configurations, differing as shown in the thickness of the Mo transition layer, are annealed for 30 minutes at 400 °C following deposition and then measured in a polar Kerr magnetometer with the applied magnetic field perpendicular to the plane of the layers. The results are shown in Fig. 3.

The low field loops and the high field loops (see inset) indicate that there are only perpendicular magnetized components in these samples. With the thicker Mo layer (t>=1.2 nm), the Co/Ni multilayer (here, 6 bilayers of Co/Ni) and the FeCoB layer have a separate switching field. It is found that the FeCoB switches at a lower field and the Co/Ni multilayer switches at a higher field. This may indicate that the magnetic coupling between them, most likely RKKY, becomes weaker with thicker Mo. This would imply that the PMA in the Co/Ni multilayer does not originate from the underlying PMA structure of the FeCoB via the long range RKKY coupling, but rather originates from its own interfacial PMA as a result of the adjacent Mo seed layer. With thinner Mo layers (t<=1.0 nm), the Co/Ni multilayer and the FeCoB layer switch together. These results indicate the role of the Mo layer and, therefore, show that that the Mo layer is a good seed layer for promoting PMA in Co/Ni multilayers. We conclude that the Mo provides a good template for the FCC(111) growth of the Co/Ni multilayers in spite of the presumable BCC(001) orientation of the underlying FeCoB. It should be noted that without the Mo transition layer, the same structure would not be PMA.

Referring now to Fig. 4, there is shown the magnetoresistance of a patterned MTJ device employing the structure of deposition #1 above. This graph clearly indicates the compatibility of Mo with MTJ devices. It should be noted that the switching shoulder of sample #1 as shown in Fig. 3 is understood as a switching that is associated with nucleation and propagation of magnetic domains in the magnetic layer. This switching shoulder is not expected in actual sub-micron/nano-sized MTJ devices for which a domain nucleation is energetically unfavorable as shown by the data of Fig. 3.

In summary, an important aspect of this disclosure relates to the crystal structure of the Mo layer. The crystal symmetry of Mo is known to be BCC at room temperature. Therefore, it naturally matches with the BCC structure of FeCoB in this study. On the other hand, Mo is reported to have a relatively good lattice matching with Ni and Co with the orientation relationship of Mo(110)/Ni(111) and Mo(110)/FCC-Co(111) (see F. Martin et al., Appl. Surf. Sci., 188, 90 (2002)). It is our belief, based on these results and the theory, that these crystal properties help to facilitate the BCC to FCC transition and, therefore, to promote the good PMA characteristics in the Co/Ni multilayer obtained in this experiment. Based on known similar properties of Nb and Vanadium (V), it is expected that those elements will provide good seed layer candidates as well.

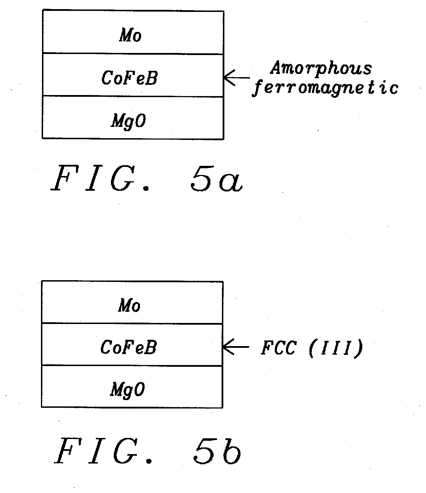

Finally, referring to Fig. 5 (a), there is shown a configuration where a layer of Mo has been used as a capping layer over a ferromagnetic layer, such as a layer of CoFeB. In this situation, the CoFeB has been formed on layer of MgO (as shown above in Fig. 1(b)). The layer of CoFeB is, at this point of the deposition process, an amorphous layer. However, after subjecting the structure of Fig. 5(a) to an annealing process, the layer of CoFeB, as shown in Fig. 5(b) is found to have acquired an FCC (111) structure. The Mo capping layer has served as a template for the crystal formation even though it is formed as a capping layer. Capping layers of V and Nb should have the same template effect under similar annealing processes.

As is finally understood by a person skilled in the art, the detailed description given above is illustrative of the present disclosure rather than limiting of the present disclosure. Revisions and modifications may be made to methods, materials, structures and dimensions employed in forming and providing a multilayer structure of differing crystal symmetries connected by a transition layer and, thereby, capable of maintaining PMA properties originating in an interface, while still forming and providing such a structure in accord with the present invention as defined by the appended claims.

**Claims**

1. A method of forming a magnetic thin film structure having perpendicular magnetic anisotropy PMA, comprising:

   providing a ferromagnetic layer formed of or containing Fe, wherein said ferromagnetic layer has an interface at which a PMA originates;
   forming a multilayered thin film structure over or under said interface, wherein said multilayered thin film structure includes PMA supporting material layers of different crystal symmetries comprising layers of the materials Co/Ni, Co/Ni/Pt or Co/Ni/Fe/Pt;
   forming a transition layer between each pair of layer having different crystal symmetry, wherein said transition layer is a layer of Mo; and
   forming a capping layer on said PMA supporting material layers of different crystal symmetries, wherein said capping layer is a layer of Mo so that said capping layer acts as a crystal structure inducing template to enhance the formation of an FCC (111) structure in layers beneath said capping layer
   wherein said transition layer promotes a matching between said different crystal symmetries, thereby causing said PMA to be propagated within each of said layers having a different crystal symmetry.

2. The method of claim 1 wherein the different crystal symmetries are BCC (body centered cubic) and FCC (face centered cubic).

3. The method of claim 1 wherein said transition layer of Mo facilitates a smooth transition between a BCC crystal symmetry and an FCC crystal symmetry.

4. The method of claim 1 wherein said material layers include layers of materials that support PMA but may have different crystal symmetries, including layers of the materials Co/Ni, (Co,Fe)/Pt, (Co, Fe)/Pd, Co/Ru, Co/Ni/Pt, and Co/Ni/Fe/Pt.

5. The method of claim 1 wherein said magnetic thin film structure having PMA is a capped TMR device, wherein said ferromagnetic layer is a free layer formed of FeCoB and said multilayered thin film structure is a laminated magnetic pinning multi-layer formed as a repetitively multi-layered structure of Co/Ni layers separated by transition layers of Mo and wherein said pinning layer contacts an MgO layer at a lower interfacial surface and maintains a PMA through crystal-structure matching induced by said transition layers.

6. The method of claim 5 wherein said free layer of FeCoB is approximately 1.2 nm in thickness.

7. The method of claim 5 wherein said transition layer of Mo is between 1.0 and 1.4 nm in thickness.

8. The method of claim 5 wherein said Co layer is of a thickness between approximately $5 \times 10^{-2}$ nm and $5 \times 10^{-1}$ nm and said Ni layer is of a thickness between approximately $2 \times 10^{-1}$ nm and 1 nm.

9. The method of claim 1 wherein said magnetic thin film structure having PMA is a capped TMR device, wherein said ferromagnetic layer is a pinned layer formed of FeCoB and said multilayered thin film structure is a laminated magnetic free layer formed as a repetitively multi-layered structure of Co/Ni layers separated by a transition layer of Mo from said pinned layer and wherein said free layer contacts an MgO layer at an upper interfacial surface and maintains a PMA through crystal-structure matching induced by said transition layers.

10. A magnetic thin film structure having perpendicular magnetic anisotropy PMA comprising:

a layer having BCC (body centered cubic) crystal symmetry;

a transition layer formed of Mo formed on said BCC layer, wherein said transition layer promotes growth of FCC (face centered cubic) crystal symmetry;

a multilayer of FCC materials formed on said transition layer, wherein said multilayer includes at least one layer of magnetic material having PMA; and

a capping layer formed on saidmultilayer of FCC materials, wherein said capping layer is a layer of Mo so that said capping layer acts as a crystal structure inducing template to enhance the formation of an FCC (111) structure in layers beneath said capping layer.

11. The magnetic thin film structure of claim 10 wherein said at least one layer having FCC crystal symmetry is a single layer or multilayer based on Co or Ni or its alloys.

12. The magnetic thin film structure of claim 10 wherein said at least one layer having BCC crystal symmetry is a layer of FeCoB.

13. The magnetic thin film structure of claim 10, wherein said material layers include layers of materials that support PMA, including layers of the materials Co/Ni, (Co,Fe)/Pt, (Co, Fe)/Pd, Co/Ru, Co/Ni/Pt, and Co/Ni/Fe/Pt.

14. The magnetic thin film device of claim 10 wherein said free layer of FeCoB is approximately 1.2 nm in thickness.

15. The magnetic thin film device of claim 10 wherein said transition layer of Mo is between 1.0 and 1.4 nm in thickness.

16. The magnetic thin film device of claim 10 wherein said Co layer is of a thickness between approximately $5x10^{-2}$ nm and $5x10^{-1}$ nm and said Ni layer is of a thickness between approximately $2x10^{-1}$ nm and 1 nm.

**Patentansprüche**

1. Verfahren zur Herstellung einer magnetischen Dünnfilmstruktur mit senkrechter magnetischer Anisotropie (perpendicular magnetic anisotropy), PMA, umfassend:

Bereitstellen einer ferromagnetischen Schicht, die aus Fe besteht oder Fe enthält, wobei die ferromagnetische Schicht eine Grenzfläche aufweist, an der eine PMA entsteht;

Ausbilden einer mehrschichtigen Dünnfilmstruktur über oder unter der Grenzfläche, wobei die mehrschichtige Dünnfilmstruktur PMA-Trägermaterialschichten verschiedener Kristallsymmetrien enthält, die Schichten aus den Materialien Co/Ni, Co/NilPt oder Co/Ni/Fe/Pt umfassen;

Bilden einer Übergangsschicht zwischen jedem Paar von Schichten mit unterschiedlicher Kristallsymmetrie, wobei die Übergangsschicht eine Schicht aus Mo ist; und

Ausbilden einer Deckschicht auf den PMA-Trägermaterialschichten mit unterschiedlichen Kristallsymmetrien, wobei die Deckschicht eine Schicht aus Mo ist, so dass die Deckschicht als eine Kristallstruktur induzierende Schablone wirkt, um die Ausbildung einer FCC (111)-Struktur in Schichten unterhalb der Deckschicht zu verbessern,

wobei die Übergangsschicht eine Anpassung zwischen den verschiedenen Kristallsymmetrien fördert und dadurch bewirkt, dass sich die PMA in jeder der Schichten, die eine andere Kristallsymmetrie aufweisen, ausbreitet.

2. Verfahren nach Anspruch 1, wobei die unterschiedlichen Kristallsymmetrien BCC (kubisch-raumzentriert) und FCC (kubisch-flächenzentriert) sind.

3. Verfahren nach Anspruch 1, wobei die Übergangsschicht aus Mo einen sanften Übergang zwischen einer BCC-Kristallsymmetrie und einer FCC-Kristallsymmetrie ermöglicht.

4. Verfahren nach Anspruch 1, wobei die Materialschichten Schichten aus Materialien umfassen, die PMA unterstützen, aber unterschiedliche Kristallsymmetrien aufweisen können, einschließlich Schichten aus den Materialien Co/Ni, (Co,Fe)/Pt, (Co, Fe)/Pd, ColRu, Co/Ni/Pt und Co/Ni/Fe/Pt.

5. Verfahren nach Anspruch 1, wobei die magnetische Dünnfilmstruktur mit PMA eine gedeckte TMR-Vorrichtung ist, wobei die ferromagnetische Schicht eine freie Schicht ist, die aus FeCoB gebildet ist, und die mehrschichtige Dünnfilmstruktur eine laminierte magnetische Pinning-Mehrschicht ist, die als eine sich wiederholende Mehrschichtstruktur aus Co/Ni-Schichten gebildet ist, die durch Übergangsschichten aus Mo getrennt sind, und wobei die Pinning-Schicht eine MgO-Schicht an einer unteren Grenzfläche berührt und ein PMA durch Kristallstrukturanpassung aufrechterhält, die durch die Übergangsschichten induziert wird.

6. Verfahren nach Anspruch 5, wobei die freie Schicht aus FeCoB eine Dicke von etwa 1,2 nm aufweist.

**7.** Verfahren nach Anspruch 5, wobei die Übergangsschicht aus Mo eine Dicke zwischen 1,0 und 1,4 nm aufweist.

**8.** Verfahren nach Anspruch 5, wobei die Co-Schicht eine Dicke zwischen etwa $5 \times 10^{-2}$ nm und $5 \times 10^{-1}$ nm und die Ni-Schicht eine Dicke zwischen etwa $2 \times 10^{-1}$ nm und 1 nm aufweist.

**9.** Verfahren nach Anspruch 1, wobei die magnetische Dünnfilmstruktur mit PMA eine gedeckelte (tunneling magnetoresistive) TMR-Vorrichtung ist, wobei die ferromagnetische Schicht eine aus FeCoB gebildete festsitzende Schicht ist und die mehrschichtige Dünnfilmstruktur eine laminierte magnetische freie Schicht ist, die als eine sich wiederholende mehrschichtige Struktur aus Co/Ni-Schichten gebildet ist, die durch eine Übergangsschicht aus Mo von der festsitzenden Schicht getrennt sind, und wobei die freie Schicht eine MgO-Schicht an einer oberen Grenzfläche berührt und eine PMA durch Kristallstrukturanpassung aufrechterhält, die durch die Übergangsschichten induziert wird.

**10.** Magnetische Dünnschichtstruktur mit senkrechter magnetischer Anisotropie, PMA, umfassend:

eine Schicht mit BCC-Kristallsymmetrie (kubisch-raumzentriert);
eine aus Mo gebildete Übergangsschicht, die auf der BCC-Schicht ausgebildet ist, wobei die Übergangsschicht das Wachstum der FCC-Kristallsymmetrie (kubisch flächenzentriert) fördert;
eine auf der Übergangsschicht gebildete Mehrfachschicht aus FCC-Materialien, wobei die Mehrfachschicht mindestens eine Schicht aus magnetischem Material mit PMA enthält; und
eine Deckschicht, die auf der Mehrfachschicht aus FCC-Materialien gebildet ist, wobei die Deckschicht eine Mo-Schicht ist, so dass die Deckschicht als eine Kristallstruktur induzierende Schablone wirkt, um die Bildung einer FCC (111)-Struktur in Schichten unterhalb der Deckschicht zu verbessern.

**11.** Magnetische Dünnfilmstruktur nach Anspruch 10, wobei die mindestens eine Schicht mit FCC-Kristallsymmetrie eine Einzelschicht oder Mehrfachschicht auf der Basis von Co oder Ni oder deren Legierungen ist.

**12.** Magnetische Dünnfilmstruktur nach Anspruch 10, wobei die mindestens eine Schicht mit BCC-Kristallsymmetrie eine Schicht aus FeCoB ist.

**13.** Magnetische Dünnfilmstruktur nach Anspruch 10, wobei die Materialschichten Schichten aus Materialien umfassen, die PMA unterstützen, einschließlich Schichten aus den Materialien Co/Ni, (Co, Fe)/Pt, (Co, Fe)/Pd, Co/Ru, Co/NilPt, und Co/Ni/FelPt.

**14.** Magnetische Dünnschichtvorrichtung nach Anspruch 10, wobei die freie Schicht aus FeCoB etwa 1,2 nm dick ist.

**15.** Magnetische Dünnschichtvorrichtung nach Anspruch 10, wobei die Übergangsschicht aus Mo zwischen 1,0 und 1,4 nm dick ist.

**16.** Magnetische Dünnschichtvorrichtung nach Anspruch 10, wobei die Co-Schicht eine Dicke zwischen etwa $5 \times 10^{-2}$ nm und $5 \times 10^{-1}$ nm und die Ni-Schicht eine Dicke zwischen etwa $2 \times 10^{-1}$ nm und 1 nm aufweist.

**Revendications**

**1.** Un procédé de formation d'une structure de film mince magnétique ayant une anisotropie magnétique perpendiculaire PMA, comprenant :

la fourniture d'une couche ferromagnétique formée à partir de ou contenant du fer, dans lequel la couche ferromagnétique a une interface à laquelle est générée une PMA ;
la formation d'une structure de film mince multicouches sur ou sous ladite interface, dans lequel ladite structure de film mince magnétique multicouches comporte des couches de matériau de support de PMA de différentes symétries cristalline comprenant des couches de matériau Co/Ni, Co/Ni/Pt ou Co/Ni/Fe/Pt ;
la formation d'une couche de transition entre chaque paire de couche de symétrie cristalline distincte, dans lequel ladite couche de transition est une couche de Mo ; et
la formation d'une couche de recouvrement sur lesdites couches de matériau de support de PMA de différentes symétries cristallines, dans lequel ladite couche de recouvrement est une couche de Mo de telle sorte que ladite couche de recouvrement agit en tant que structure cristalline induisant une amélioration de la formation d'une structure FCC (111) dans les couches sous ladite couche de recouvrement ;
dans lequel ladite couche de transition favorise une correspondance entre lesdites symétries cristallines différentes, provoquant ainsi une propagation de ladite PMA au sein de chacune desdites couches ayant une symétrie cristalline distincte.

**2.** Le procédé de la revendication 1 dans lequel les différentes symétries cristallines sont BCC (cubique centrée sur le bord) et FCC (cubique centrée sur la face).

3. Le procédé de la revendication 1 dans lequel ladite couche de transition de Mo facilite une transition douce entre une symétrie cristalline BCC et une symétrie cristalline FCC.

4. Le procédé de la revendication 1 dans lequel lesdites couches de matériau comporte des couches de matériau soutenant la PMA mais pouvant avoir différentes symétries cristalline, incluant des couches de matériau Co/Ni, (Co,Fe)/Pt, (Co, Fe) /Pd, Co/Ru, Co/Ni/Pt, et Co/Ni/Fe/Pt.

5. Le procédé de la revendication 1 dans lequel ladite structure de film mince magnétique ayant de la PMA est un dispositif TMR couvert, dans lequel ladite couche ferromagnétique est une couche libre formée de FeCoB et ladite structure de film mine multicouches est une multi-couche d'ancrage magnétique laminée formée d'une structure multicouches répétitive de couches Co/Ni séparées par des couches de transition de Mo et dans lequel ladite couche d'ancrage fait contact avec une couche MgO à une surface interfaciale inférieure et maintient une PMA au travers une correspondance de structure cristalline induite par lesdites couches de transition.

6. Le procédé de la revendication 5 dans lequel ladite couche libre de FeCoB a une épaisseur approximativement égale à 1.2 nm.

7. Le procédé de la revendication 5 dans lequel ladite couche de transition de Mo a une épaisseur comprise entre 1.0 et 1.4 nm.

8. Le procédé de la revendication 5 dans lequel ladite couche Co a un épaisseur approximativement comprise entre $5 \times 10^{-2}$ nm et $5 \times 10^{-1}$ nm et ladite couche de Ni est d'une épaisseur approximativement comprise entre $2 \times 10^{-1}$ nm et 1nm.

9. Le procédé de la revendication 1 dans lequel ladite structure de film mince magnétique ayant de la PMA est un dispositif TMR recouvert, dans lequel la couche ferromagnétique est une couche ancrée formée de FeCoB et ladite structure de film mince multicouches est une couche libre magnétique laminée formée d'une structure multicouches répétitive de couches Co/Ni séparées de ladite couche ancrée par une couche de transition de Mo et dans lequel ladite couche libre fait contact avec une couche MgO à une surface interfaciale supérieure et maintient une PMA au travers une correspondance de structures cristalline induite par lesdites couches de transition.

10. Une structure de film mince magnétique ayant une anisotropie magnétique perpendiculaire PMA, comprenant :

une couche ayant une symétrie cristalline BCC (cubique centrée au corps) ;
une couche de transition formée de Mo formée sur ladite couche BCC, dans laquelle ladite couche de transition favorise la croissance de symétries cristalline FCC (cubique centrée face) ;
une multicouche de matériaux FCC formée sur ladite couche de transition, dans laquelle ladite multicouche comporte au moins une couche de matériau magnétique ayant de la PMA ; et
une couche de recouvrement formée sur ladite multicouche de matériaux FCC, dans laquelle ladite couche de recouvrement est une couche de Mo de telle sorte que ladite couche de recouvrement agit comme une structure cristalline induisant une amélioration de la formation d'une structure FCC (111) dans des couches en dessous de ladite couche de recouvrement.

11. La structure de film mince magnétique de la revendication 10 dans laquelle au moins une couche ayant une symétrie cristalline FCC est une couche simple ou une multicouche basée sur Co ou Ni ou ses alliages.

12. La structure de film mince magnétique de la revendication 10 dans laquelle ladite couche au moins ayant une symétrie cristalline FCC est une couche de FeCoB.

13. La structure de film mince magnétique de la revendication 10, dans laquelle lesdites couches de matériau comporte des couches de matériau supportant la PMA, comportant des couches de matériaux Co/Ni, (Co,Fe)/Pt, (Co, Fe) /Pd, Co/Ru, Co/Ni/Pt, et Co/Ni/Fe/Pt.

14. La structure de film mince magnétique de la revendication 10 dans laquelle ladite couche libre de FeCoB a une épaisseur approximativement égale à 1.2 nm.

15. La structure de film mince magnétique de la revendication 10 dans laquelle ladite couche de transition de Mo a une épaisseur comprise entre 1.0 et 1.4 nm.

16. La structure de film mince magnétique de la revendication 10 dans laquelle ladite couche Co a un épaisseur approximativement comprise entre $5 \times 10^{-2}$ nm et $5 \times 10^{-1}$ nm et ladite couche Ni a une épaisseur approximativement comprise entre $2 \times 10^{-1}$ nm et 1nm.

| PMA layer (FCC) |
| :---: |
| Seed Layer |
| Buffer Layer |

(a)

| PMA layer (BCC) |
| :---: |
| MgO |
| Under layer |

(b)

| PMA layer (FCC) |
| :---: |
| Seed Layer |
| PMA layer (BCC) |
| MgO |
| Under layer |

(c)

## FIG. 1 - Prior Art

| Ta |
| :---: |
| Co/Ni x 6 (FCC) |
| Mo |
| FeCoB (BCC) |
| MgO |
| FeCoB (BCC) |
| Under layer |

## FIG. 2

FIG. 3

FIG. 4

FIG. 5a

FIG. 5b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7666529 B, Girt
- US 20120141836 A, Wang
- US 2013028013 A
- WO 2012160937 A
- US 2014097509 A
- US 2012068139 A
- US 2011149647 A
- US 2013078482 A
- WO 2014051943 A

**Non-patent literature cited in the description**

- **DAALDEROP et al.** *Phys. Rev. Lett.,* 1992, vol. 68, 682
- **JI-HO PARK et al.** Perpendicular Magnetic Tunnel Junctions with CoFe/Pd Multilayer Electrodes and an Mgo Barrier. *IEEE TRANSACTIONS ON MAGNETICS,* 01 October 2009, vol. 45 (10), 3476-3479
- **IKEDA et al.** *Nature Mater.,* 2010, vol. 9, 721
- **BUTLER et al.** *Phys. Rev B,* 2001, vol. 63, 054416
- **F. MARTIN et al.** *Appl. Surf. Sci.,* 2002, vol. 188, 90